# EUROPEAN PATENT SPECIFICATION

(11) **EP 2 869 329 B1**
(45) Date of publication and mention of the grant of the patent: **30.12.2020**
(21) Application number: 12844652.3
(22) Date of filing: 13.11.2012
(51) Int. Cl.: H01L 21/336

(54) **Method for manufacturing a thin film transistor**
Herstellungsverfahren eines Dünnschichttransistors
Procédé de fabrication d'un transistor à couches minces

(30) Priority: 29.06.2012 CN 201210226591
(43) Date of publication of application: 06.05.2015
(73) Proprietor: BOE Technology Group Co., Ltd., Beijing 100015 (CN)
(72) Inventor: LIANG, Yinan, Beijing 100176 (CN)
(74) Representative: Brötz, Helmut
(86) International application number: PCT/CN2012/084543
(87) International publication number: WO 2014/000367

(56) References cited:
- CN-A- 1 351 371
- CN-A- 1 355 554
- CN-A- 1 431 718
- CN-A- 1 773 720
- US-A1- 2002 074 548
- US-A1- 2002 115 242
- US-A1- 2002 142 528
- US-B1- 6 784 034

## Description

### FIELD OF THE INVENTION

Embodiments of the invention relate to a manufacturing method of a thin film transistor.

### BACKGROUND OF THE INVENTION

Organic Light-Emitting Display (OLED) is a new flat-panel display device, and it has a broad application prospect because of its advantages, such as simple preparation processes, low cost, fast response speed, easiness for realizing a color display and a large-screen display, low power consumption, easiness for matching with an integrated driver circuit, high brightness, a wide range of adaptive working temperature, small volume, light weight, and easiness for realizing a flexible display, etc.

According to different driving modes, OLEDs can be classified into two types: a Passive-Matrix OLED (PMOLED, Passive-Matrix Organic Light Emission Display) and an Active-Matrix OLED (AMOLED, Active-Matrix Organic Light Emission Display). The passive matrix driving mode, although simple in processes and relatively low in cost, cannot meet the requirements of a high-resolution large-size display due to its disadvantages such as crosstalk, high power consumption, and short service life, etc. In contrast, the active matrix driving mode, because thin film transistors (TFTs) are added on the panel such that pixel units are capable of emitting light during every frame time, requires small driving current, and has low power consumption and longer service life, and therefore can meet the requirements of a high-resolution multi-grayscale large-size display.

At present, for an AMOLED display driver circuit, there are mainly two types: one is the use of amorphous silicon (a-Si) TFTs; the other is the use of poly silicon (p-Si) TFTs. The a-Si TFT technology, although simple in processes and low in cost, cannot provide sufficient drive current due to its very low carrier mobility, and since amorphous silicon TFTs can only provide N-type devices, it also has a stability problem under the effect of a long-term stress. The poly silicon TFT, because of its high carrier mobility and fast response speed, is easy for realizing a large-area dynamic video display. Meanwhile, by virtue of the high carrier mobility, the poly silicon TFTs can be utilized to integrate a peripheral driver circuit onto the display rear panel; this greatly reduces external leading wires, and reduces the complexity of the peripheral driver circuit. Currently, poly silicon TFTs are commonly adopted in the world in the research and development of an AMOLED rear panel.

Compared with amorphous silicon TFT technology which requires only 4-5 times of photolithography, low-temperature poly silicon TFT technology is more complex in processes and higher in cost. All the currently known manufacturing procedures of a low-temperature poly silicon thin film transistor usually require 6 or more times of photolithography, with complex processes, high manufacturing costs, and a relative long production cycle. The more times of photolithography, the more difficult to improve the yield. Therefore, the times of photolithography can be used to measure the complexity of a manufacturing procedure of a low-temperature poly silicon thin film transistor, and a reduction in the times of photolithography means a reduction in manufacturing costs.

Thus, it is desired to reduce the times of photolithography, in order to shorten the production cycle of a low-temperature poly silicon thin film transistor, and to reduce the manufacturing costs of the low-temperature poly silicon thin film transistor.
From US 2002/0115242 A1 it is known a method and an apparatus for fabricating a thin film transistor including crystalline active layer. US 2002/0142528 A1 discloses a method for fabricating a thin film transistor including a crystalline silicon active layer. Further, a method for fabricating a thin film transistor is also disclosed by US 6,784,034 B1.

The document US2002074548 discloses another alternative method for manufacturing a thin film transistor involving the metal induced crystallisation of the active layer.

### SUMMARY OF THE INVENTION

The present invention provides a manufacturing method of a thin film transistor as defined in the appended claims, comprising steps of:
forming a buffer layer and an active film sequentially on a substrate, and forming an active layer through a patterning process on the active film;
forming a gate insulating layer and a gate electrode sequentially;
forming openings for Ni deposition in the gate insulating layer so as to expose a part of source/drain regions of the active layer;
forming a dielectric layer having source/drain contact holes in a one-to-one correspondence with the openings for Ni deposition; and
forming source/drain electrodes which are connected with the active layer via the source/drain contact holes and openings for Ni deposition.

Materials of the active layer and the gate electrode are amorphous silicon thin film, respectively; between the step of forming the openings for Ni deposition and the step of forming the dielectric layer, the method further comprises a step of:

crystallizing the amorphous silicon thin film material of both the active layer and the gate electrode into poly silicon thin film material by utilizing a metal-induced lateral crystallization method.

In one embodiment of the invention, the step of crystallizing the amorphous silicon thin film material of both the active layer and the gate electrode into poly silicon thin film material by utilizing the metal-induced lateral crystallization method comprises:
depositing metal Ni in the openings for Ni deposition and on the gate electrode, and implanting source/drain ions into the openings for Ni deposition so as to form the source/drain regions, then performing a high-temperature annealing.

In one embodiment of the invention, materials of the buffer layer and the dielectric layer are SiO₂, SiNₓ, or a mixture thereof, respectively; material of the source/drain electrodes is Mo, a conductive metal, or a conductive alloy.

In one embodiment of the invention, both a number of the openings for Ni deposition and a number of the source/drain contact holes are two, respectively.

Another aspect of the embodiments of the invention further provides a manufacturing method of an array substrate, comprising
the steps of the manufacturing method according to the above paragraphs 0007-0014 ; and
forming a pixel defining and insulating layer so as to form a pixel array.

In one embodiment of the invention, the step of crystallizing the amorphous silicon thin film material of both the active layer and the gate electrode into poly silicon thin film material by utilizing the metal-induced lateral crystallization method comprises:
depositing metal Ni in the openings for Ni deposition and on the gate electrode, and implanting source/drain ions into the openings for Ni deposition so as to form the source/drain regions, then performing a high-temperature annealing.

The utilization of the above manufacturing method in accordance with the embodiments of the present invention to manufacture a thin film transistor, adopts only 5 times of photolithography process, and thus simplifies the processing procedure, reduces the production costs, and improves the yield. The use of metal-induced lateral crystallization technology to implement a poly silicon crystallization process, and the use of a low-temperature poly silicon layer as a gate electrode, improve the interface with gate dielectric layer, and can lower the threshold voltage and reduce the leakage current, and thus achieve a technical effect of a simplified processing procedure and an enhanced device performance. The thin film transistor manufactured by utilizing the above manufacturing method in accordance with the embodiments of the present invention can be applied in fields such as an Active-Matrix Organic Light-Emitting Display (AMOLED) and a Low-Temperature Poly silicon thin film-transistor Liquid Crystal Display (LTPS-LCD), etc.

### BRIEF DESCRIPTION OF THE DRAWINGS

In order to clearly illustrate the technical solutions of the embodiments of the invention, the drawings of the embodiments will be briefly described in the following; it is obvious that the described drawings are only related to some embodiments of the invention and thus are not limitative of the invention.
FIG. 1 is a schematic structural diagram of a thin film transistor shown in step A in a first embodiment of the present invention;
FIG. 2 is a schematic structural diagram of the thin film transistor shown in step B in the first embodiment of the present invention;
FIG. 3 is a schematic structural diagram of the thin film transistor shown in step C in the first embodiment of the present invention;
FIG. 4 is a schematic structural diagram of the thin film transistor shown in step D in the first embodiment of the present invention;
FIG. 5 is a schematic structural diagram of the thin film transistor shown in step E in the first embodiment of the present invention;
FIG. 6 is a schematic structural diagram of the thin film transistor shown in step F in the first embodiment of the present invention; and
FIG. 7 is a schematic structural diagram of the thin film transistor shown in step G in the first embodiment of the present invention.

### DETAILED DESCRIPTION OF THE PREFERRED EMBODIMENTS

In order to make objects, technical details and advantages of the embodiments of the invention apparent, the technical solutions of the embodiments will be described in a clearly and fully understandable way in connection with the drawings related to the embodiments of the invention. It is obvious that the described embodiments are just a part but not all of the embodiments of the invention. Based on the described embodiments herein, those skilled in the art can obtain other embodiment(s), without any inventive work, which should be within the scope of the invention.

At present, amorphous silicon crystallization methods for forming poly silicon may include: an Excimer Laser Annealing (ELA) method, a Sequential Lateral Solidification (SLS) method, a Metal-Induced Crystallization (MIC) method, or a Metal-Induced Lateral Crystallization (MILC) method.

Among these methods, MILC technology, compared with ELA and SLS technologies, is better in uniformity of TFT dcviccs, and easier to meet the requirements of a large-size AMOLED display; meanwhile, the MILC technology is cheaper in costs. Moreover, MILC technology, compared with MIC technology, can effectively reduce residual-metal contamination in a channel region. Therefore, MILC technology is very suitable for applications in a future large-size AMOLED.

### The First Embodiment

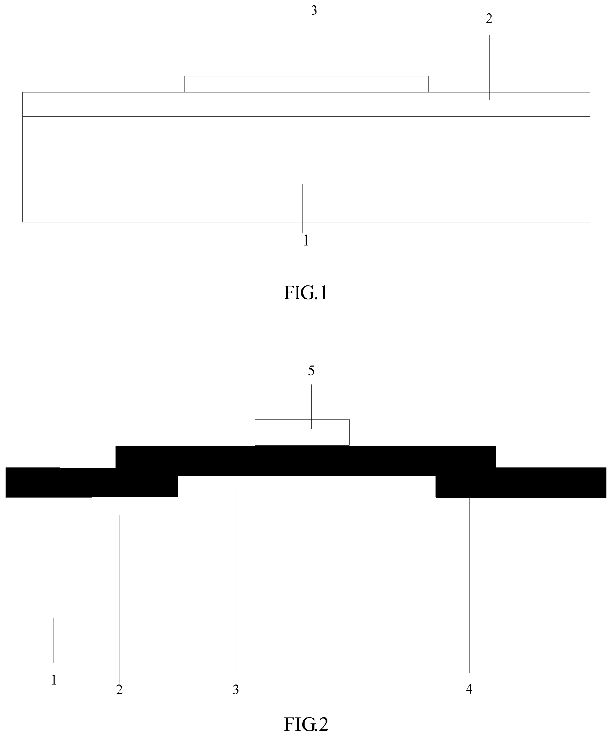

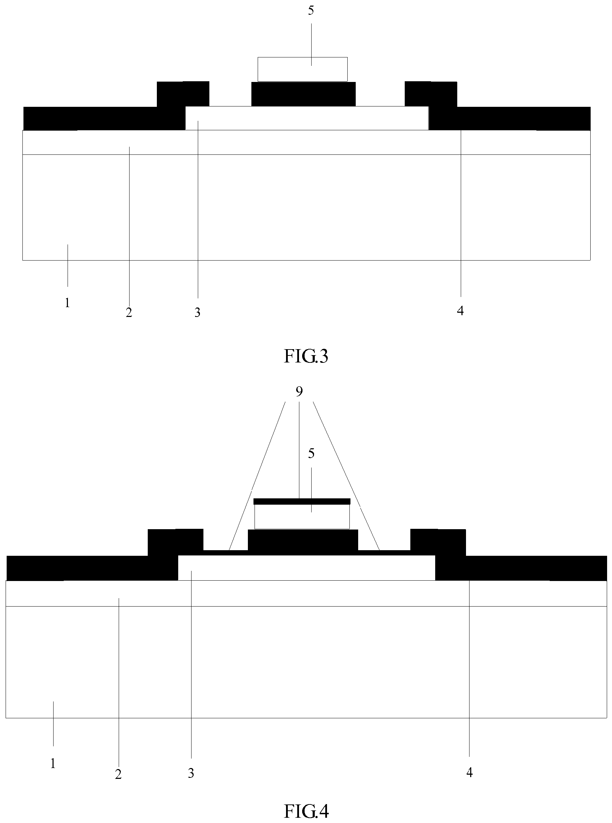

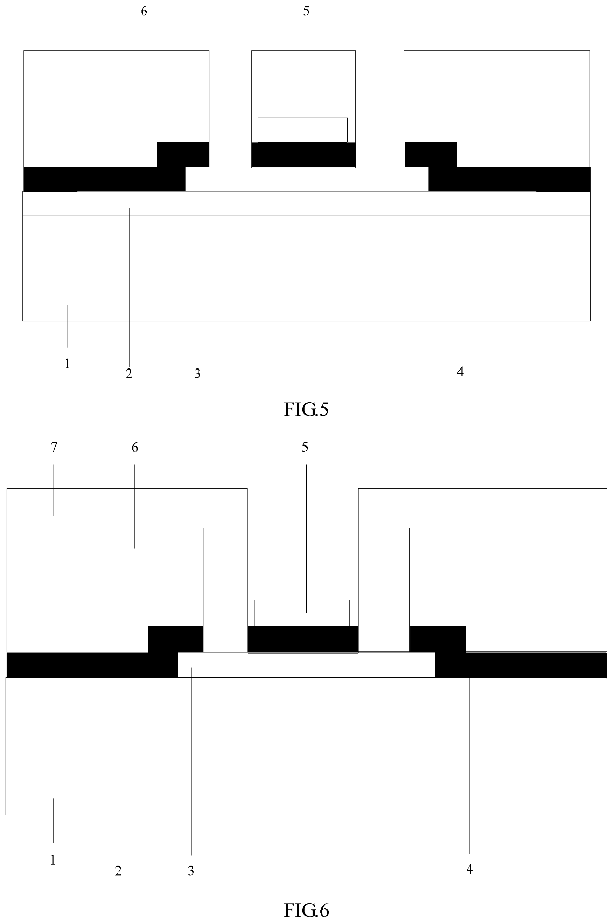

With reference to FIG. 1 to FIG. 6, the embodiment of the invention provides a manufacturing method of a thin film transistor, and this technology can reduce the number of masks required in the manufacturing procedure, thereby simplifying the processing procedure and improving the yield; the method comprises the steps as follows:
Step A: as shown in FIG. 1, a buffer layer 2 and an active layer are sequentially formed on a substrate 1 which may be a substrate of quartz glass, ordinary glass or plastic, or the like; the buffer layer 2 is used to protect a channel region, and the buffer layer 2 may have a thickness of 2000 ∼ 4000 Å (angstrom), and the material of the buffer layer 2 may be SiO₂ (silicon dioxide), SiNₓ (silicon nitride), or a mixture thereof; the active layer may have a thickness of 500 ∼ 800 Å, and the material of the active layer may be an amorphous silicon (a-Si) thin film, and then an active layer 3 is formed, for example through a patterning process (i.e., an active-layer mask process, referred to as Active-Mask) performed on the amorphous silicon (a-Si) thin film;
Step B: as shown in FIG. 2, a gate insulating layer 4 and a gate electrode layer are sequentially formed, in which the gate insulating layer 4 may have a thickness of 800 ∼ 1500 Å; the gate electrode layer may have a thickness of 1500 ∼ 2500 Å, and the material of the gate electrode layer may be an amorphous silicon (a-Si) thin film, and then a gate electrode 5 can be formed, for example through a patterning process performed on the gate electrode layer;
Step C: as shown in FIG. 3, Ni (Nickel) deposition openings are formed, for example through a patterning process (i.e., a Ni mask process, referred to as Ni-Mask) performed on the gate insulating layer; for instance, two Ni (Nickel) deposition openings may be formed;
Step D: as shown in FIG. 4, by utilizing a metal-induced lateral crystallization method, the amorphous silicon thin film material of both the active region 3 and the gate electrode 5 is crystallized into poly silicon thin film material;
This step specifically comprises steps as follows: metal Ni 9, as a precursor-metal used for the metal-induced lateral crystallization, is deposited in the Ni deposition openings and on the gate electrode 5, and source/drain ions are implanted into the Ni deposition openings, thus source/drain regions are formed, and then a high-temperature annealing is performed;
Step E: as shown in FIG. 5, a dielectric layer 6 is formed, and the dielectric layer 6 may have a thickness of 2000 ∼ 4000 Å, and the material of the dielectric layer 6 may be SiO₂, SiNₓ or a mixture of thereof; and then source/drain contact holes arc formed in positions corresponding to the Ni deposition openings, for example through a patterning process (i.e., a contact-hole mask process, referred to as CNT-Mask) performed on the dielectric layer 6;
Step F: as shown in FIG. 6, a source/drain metal layer is formed, and the source/drain metal layer may have a thickness of 2000 ∼ 3500 Å, and the material of the source/drain metal layer may be Mo or other conductive metals or alloys; and then source/drain electrodes 7 are formed, for example through a patterning process (i.e., a source/drain mask process, referred to as SD-Mask) performed on the source/drain metal layer, and the source/drain electrodes 7 are connected with the active region 3 via the source/drain contact holes and the Ni deposition openings, meanwhile the source/drain electrodes 7 are separated from the gate electrode 5 by the dielectric layer 6.

Each patterning process described in the embodiment, generally comprises processes such as applying photoresist, exposing with a mask, developing, etching, and removing photoresist, etc.

The utilization of the above manufacturing method in accordance with the embodiment of the present invention to manufacture a thin film transistor adopts only 5 times of photolithography processes, and thus simplifies the processing procedure, reduces the production costs, and improves the yield.

The use of metal-induced lateral crystallization technology to implement a poly silicon crystallization process, and the use of a low-temperature poly silicon layer as a gate clcctrodc, improve the interface with the gate dielectric layer, and can lower the threshold voltage and reduce the leakage current, and thus achieve a technical effect of a simplified processing procedure and an enhanced device performance.

The thin film transistor manufactured by utilizing the above manufacturing method in accordance with the embodiment of the present invention can be applied in fields such as an Active-Matrix Organic Light-Emitting Display (AMOLED) and a Low-Temperature Poly-Silicon thin film-transistor Liquid Crystal Display (LTPS-LCD), etc.

### The Second Embodiment

The manufacturing method of an array substrate in accordance with this embodiment of the invention comprises the steps of the abovc-dcscribcd manufacturing method of a thin film transistor in accordance with the first embodiment of the invention, and further comprises the steps as follows:

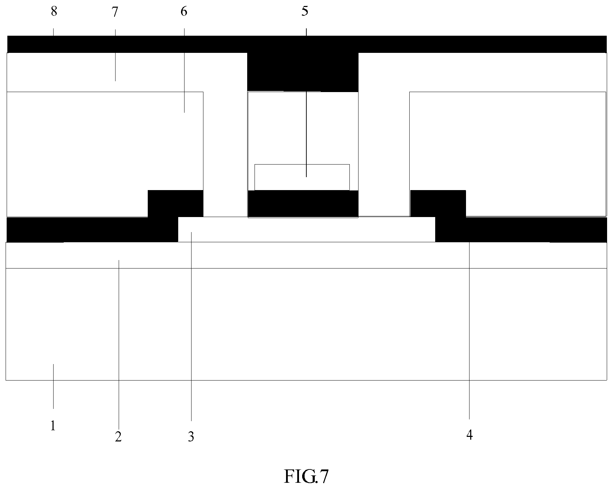

Step G: as shown in Fig.7, a pixel defining and insulating layer 8 (PI) is formed, and the pixel defining and insulating layer 8 may have a thickness of 1 ∼ 2 um; and then a pixel array may be formed, for example through a patterning process performed on the pixel defining and insulating layer 8.

The patterning process described in the embodiment, generally comprises processes such as applying photoresist, exposing with a mask, developing, etching, and removing photoresist, etc.

The utilization of the above manufacturing method in accordance with the embodiment of the present invention to manufacture an array substrate adopts only 6 times of photolithography process, and thus simplifies the processing procedure, reduces the production costs, and improves the yield.

The use of metal-induced lateral crystallization technology to implement a poly silicon crystallization process, and the use of a low-temperature poly silicon layer as a gate electrode, improve the interface with the gate dielectric layer, and can lower the threshold voltage and reduce the leakage current, and thus achieve a technical effect of a simplified processing procedure and an enhanced device performance.

The array substrate manufactured by utilizing the manufacturing method in accordance with the embodiment of the invention can be applied in fields such as an Active-Matrix Organic Light-Emitting Display (AMOLED) and a Low-Temperature Poly-Silicon thin film-transistor Liquid Crystal Display (LTPS-LCD), etc.

As shown in FIG. 5, the thin film transistor obtained by a method in accordance with the invention, comprises: a buffer layer 2 and an active region 3 sequentially formed on a substrate 1 which may be a substrate of quartz glass, ordinary glass or plastic, or the like; the buffer layer 2 is used to protect a channel region, and the buffer layer 2 may have a thickness of 2000 ∼ 4000 Å (angstrom), and the material of the buffer layer 2 may be SiO₂ (silicon dioxide), SiNₓ (silicon nitride), or a mixture thereof; the active region 3 may have a thickness of 500 ∼ 800 Å, and the material of the active region 3 may be a poly silicon thin film; the thin film transistor also comprises: a gate insulating layer 4 having (e.g., two) Ni deposition openings, a gate electrode 5, and a dielectric layer 6 having source/drain contact holes which are sequentially overlaid on the buffer layer 2 and the active region 3, the source/drain contact holes being in a one-to-one correspondence with the Ni deposition openings. The gate insulating layer 4 may have a thickness of 800 ∼ 1500 Å; the gate electrode 5 may have a thickness of 1500 ∼ 2500 Å, and the material of the gate electrode 5 may be a poly silicon thin film; the dielectric layer 6 may have a thickness of 2000 ∼ 4000 Å, and the material of the dielectric layer 6 may be SiO₂, SiNₓ or a mixture thereof; moreover, the thin film transistor comprises: source/drain electrodes 7 which are connected with the active region 3 via the source/drain contact holes and the Ni deposition openings, the source/drain electrodes 7 are separated from the gate electrode 5 by the dielectric layer 6.

In the fabrication of a thin film transistor in accordance with the invention, the use of metal-induced lateral crystallization technology to implement a poly silicon crystallization process, and the use of a low-temperature poly silicon layer as a gate electrode, improve the interface with the gate dielectric layer, and can lower the threshold voltage and reduce the leakage current, and thus achieve a technical effect of a simplified processing procedure and an enhanced device performance.

The thin film transistor obtained by a method in accordance with the invention can be applied in fields such as an Active-Matrix Organic Light-Emitting Display (AMOLED) and a Low-Temperature Poly-Silicon thin film-transistor Liquid Crystal Display (LTPS-LCD), etc.

The array substrate obtained by the method of the invention comprises a thin film transistor as described above, and further comprises:
a pixel defining and insulating layer 8 (PI) overlaid on the dielectric layer 6 and the source/drain electrodes 7, in which the pixel defining and insulating layer 8 may have a thickness of 1 ∼ 2 um, and the pixel defining and insulating layer 8 (PDL-Mask) is used to form a pixel array.

In the fabrication of an array substrate in accordance with the invention, the use of metal-induced lateral crystallization technology to implement a poly-Silicon crystallization process, and the use of a low-temperature poly silicon layer as a gate electrode, improve the interface with the gate dielectric layer, and can lower the threshold voltage and reduce the leakage current, and thus achieve a technical effect of a simplified processing procedure and an enhanced device performance.

The array substrate in accordance with the embodiment of the invention can be applied in fields such as an Active-Matrix Organic Light-Emitting Display (AMOLED) and a Low-Temperature Poly-Silicon thin film-transistor Liquid Crystal Display (LTPS-LCD), etc.

In summary, the embodiments of the present invention disclose a manufacturing method of a thin film transistor and an array substrate. The utilization of the above manufacturing method in accordance with the embodiment of the present invention to manufacture a thin film transistor adopts only 5 times of photolithography process, and thus simplifies the processing procedure, reduces the production costs, and improves the yield. The use of metal-induced lateral crystallization technology to implement a poly-Silicon crystallization process, and the use of a low-temperature poly silicon layer as a gate electrode, improve the interface with the gate dielectric layer, and can lower the threshold voltage and reduce the leakage current, and thus achieve a technical effect of a simplified processing procedure and an enhanced device performance. The thin film transistor manufactured by utilizing the above manufacturing method in accordance with the embodiment of the present invention can be applied in fields such as an Active-Matrix Organic Light-Emitting Display (AMOLED) and a Low-Temperature Poly-Silicon thin film-transistor Liquid Crystal Display (LTPS-LCD), etc.

The above are merely exemplary implementations of the present invention, but not for limiting the scope of the invention; instead, the scope of the invention should be defined by the appended claims.

## Claims

1. A manufacturing method of a thin film transistor, comprising steps of:
forming a buffer layer (2) and an active film sequentially on a substrate (1), and forming an active layer (3) through a patterning process on the active film;
forming a gate insulating layer (4) and a gate electrode (5) sequentially;
forming openings for Ni deposition in the gate insulating layer (4) so as to expose a part of source/drain regions of the active layer (3);
forming a dielectric layer (6) having source/drain contact holes in a one-to-one correspondence with the openings for Ni deposition; and
forming source/drain electrodes (7) which are connected with the active layer (3) via the source/drain contact holes and the openings for Ni deposition;
wherein materials of the active layer (3) and the gate electrode (5) are amorphous silicon thin film, respectively;
**characterized in that**, between the step of forming the openings for Ni deposition and the step of forming the dielectric layer (6), the method further comprises a step of:
crystallizing the amorphous silicon thin film material of both the active layer (3) and the gate electrode (5) into poly silicon thin film material by utilizing a metal-induced lateral crystallization method.

2. The manufacturing method according to Claim 1, wherein the step of crystallizing the amorphous silicon thin film material of both the active layer (3) and the gate electrode (5) into poly silicon thin film material by utilizing the metal-induced lateral crystallization method comprises:
depositing metal Ni in the openings for Ni deposition and on the gate electrode (5), and implanting source/drain ions into the openings for Ni deposition so as to form the source/drain regions, then performing a high-temperature annealing.

3. The manufacturing method according to any one of Claims 1-2, wherein materials of the buffer layer (2) and the dielectric layer (6) are SiO₂, SiNₓ, or a mixture thereof, respectively; material of the source/drain electrodes (7) is Mo, a conductive metal, or a conductive alloy.

4. The manufacturing method according to any one of Claims 1-3, wherein both a number of the openings for Ni deposition and a number of the source/drain contact holes are two, respectively.

5. A manufacturing method of an array substrate, comprising steps of:
the steps of the manufacturing method according to claim 1; and
forming a pixel defining and insulating layer so as to form a pixel array.

6. The manufacturing method according to Claim 5, wherein the step of crystallizing the amorphous silicon thin film material of both the active layer (3) and the gate electrode (5) into poly silicon thin film material by utilizing the metal-induced lateral crystallization method comprises:
depositing metal Ni in the openings for Ni deposition and on the gate electrode (5), and implanting source/drain ions into the openings for Ni deposition so as to form the source/drain regions, then performing a high-temperature annealing.

## Patentansprüche

1. Herstellungsverfahren für einen Dünnfilmtransistor, umfassend die Schritte:
Bilden einer Pufferschicht (2) und eines aktiven Films sequenziell auf einem Substrat (1), und Bilden einer aktiven Schicht (3) durch einen Musterbildungsprozess auf dem aktiven Film;
Bilden einer Gate-Isolierschicht (4) und einer Gate-Elektrode (5) sequenziell;
Bilden von Öffnungen für Ni-Abscheidung in der Gate-Isolierschicht (4), um einen Teil der Source-/Drain-Regionen der aktiven Schicht (3) freizulegen;
Bilden einer dielektrischen Schicht (6), aufweisend Source-/Drain-Kontaktlöcher in einer Eins-zu-eins-Entsprechung mit den Öffnungen zur Ni-Abscheidung; und
Bilden von Source-/Drain-Elektroden (7), die mit der aktiven Schicht (3) durch die Source-/Drain-Kontaktlöcher und die Öffnungen zur Ni-Abscheidung verbunden sind;
wobei Materialien der aktiven Schicht (3) und der Gate-Elektrode (5) jeweils amorpher Siliciumdünnfilm sind;
**dadurch gekennzeichnet, dass** zwischen dem Schritt des Bildens der Öffnungen zur Ni-Abscheidung und dem Schritt des Bildens der dielektrischen Schicht (6) das Verfahren außerdem einen Schritt aufweist:
Kristallisieren des amorphen Siliciumdünnfilmmaterials von sowohl der aktiven Schicht (3) als auch der Gate-Elektrode (5) in Polysiliciumdünnfilmmaterial mittels Verwendung eines metallinduzierten lateralen Kristallisationsverfahrens.

2. Herstellungsverfahren gemäß Anspruch 1, wobei der Schritt des Kristallisierens des amorphen Siliciumdünnfilmmaterials von sowohl der aktiven Schicht (3) als auch der Gate-Elektrode (5) in Polysiliciumdünnfilmmaterial mittels Verwendung des metallinduzierten lateralen Kristallisationsverfahrens umfasst:
Abscheiden von metallischem Ni in den Öffnungen zur Ni-Abscheidung und auf der Gate-Elektrode (5), und Implantieren von Source-/Drain-Ionen in die Öffnungen zur Ni-Abscheidung, um die Source-/Drain-Regionen zu bilden, und dann Durchführen eines Hochtemperatur-Glühens.

3. Herstellungsverfahren gemäß einem der Ansprüche 1-2, wobei Materialien jeweils der Pufferschicht (2) und der dielektrischen Schicht (6) SiO₂, SiNₓ, oder eine Mischung davon sind; wobei Material der Source-/Drain-Elektroden (7) Mo, ein leitfähiges Metall, oder eine leitfähige Legierung ist.

4. Herstellungsverfahren gemäß einem der Ansprüche 1-3, wobei sowohl eine Anzahl der Öffnungen zur Ni-Abscheidung und eine Anzahl der Source-/Drain-Kontaktlöcher jeweils Zwei beträgt.

5. Herstellungsverfahren eines Array-Substrats, umfassend die Schritte:
die Schritte des Herstellungsverfahrens gemäß Anspruch 1; und
Bilden einer Pixeldefinitions- und Isolierschicht, um ein Pixel-Array zu bilden.

6. Herstellungsverfahren gemäß Anspruch 5, wobei der Schritt des Kristallisierens des amorphen Siliciumdünnfilmmaterials von sowohl der aktiven Schicht (3) als auch der Gate-Elektrode (5) in Polysiliciumdünnfilmmaterial mittels Verwendung des metallinduzierten lateralen Kristallisationsverfahrens umfasst:
Abscheiden von metallischem Ni in den Öffnungen zur Ni-Abscheidung und auf der Gate-Elektrode (5), und Implantieren von Source-/Drain-Ionen in die Öffnungen zur Ni-Abscheidung, um die Source-/Drain-Regionen zu bilden, dann Durchführen eines Hochtemperatur-Glühens.

## Revendications

1. Procédé de fabrication d'un transistor à couches minces, comprenant les étapes de :
former une couche tampon (2) et un film actif de manière séquentielle sur un substrat (1) et de former une couche active (3) à travers un procédé de formation de motifs sur le film actif ;
former une couche d'isolation de porte (4) et une électrode de porte (5) de manière séquentielle ;
former des ouvertures pour le dépôt de Ni dans la couche d'isolation de porte (4) de manière à exposer une partie des régions de source/de drain de la couche active (3) ;
former une couche diélectrique (6) ayant des trous de contact de source/de drain dans une correspondance un-un avec les ouvertures pour le dépôt de Ni ; et
former des électrodes de source/de drain (7) qui sont connectées avec la couche active (3) par le biais des trous de contact de source/de drain et des ouvertures pour le dépôt de Ni ;
dans lequel des matériaux de la couche active (3) et de l'électrode de porte (5) sont des couches de silicium amorphe respectivement ;
**caractérisé en ce qu'**entre l'étape de formation des ouvertures pour le dépôt de Ni et l'étape de formation de la couche diélectrique (6), le procédé comprend en outre une étape de :
cristallisation du matériau de couches de silicium à la fois de la couche active (3) et de l'électrode de porte (5) en du matériau de couches de poly-silicium en utilisant un procédé de cristallisation latérale induite par du métal.

2. Procédé de fabrication selon la revendication 1, dans lequel l'étape de cristallisation du matériau de couches de silicium amorphe d'à la fois de la couche active (3) et de l'électrode de porte (5) en du matériau de couches de poly-silicium en utilisant le procédé de cristallisation latérale induite par du métal comprend :
de déposer du Ni métallique dans les ouvertures pour le dépôt de Ni et sur l'électrode de porte (5) et d'implanter des ions de source/de drain dans les ouvertures pour le dépôt de Ni de manière à former les régions de source/de drain, puis d'effectuer un recuit à haute température.

3. Procédé de fabrication selon l'une quelconque des revendications 1-2, dans lequel des matériaux de la couche tampon (2) et de la couche diélectrique (6) sont du SiO₂, du SiNₓ ou un mélange de ceux-ci, respectivement ; le matériau des électrodes de source/de drain (7) est du Mo, un matériau conducteur, ou un alliage conducteur.

4. Procédé de fabrication selon l'une quelconque des revendications 1-3, dans lequel à la fois un nombre des ouvertures pour le dépôt de Ni et un nombre des trous de contact de source/de drain est de deux, respectivement.

5. Procédé de fabrication d'un substrat de réseau, comprenant les étapes de :
les étapes du procédé de fabrication selon la revendication 1 ; et
formation d'une couche d'isolation et de définition de pixels de façon à former un réseau de pixels.

6. Procédé de fabrication selon la revendication 5, dans lequel l'étape de cristallisation du matériau de couches de silicium amorphe d'à la fois de la couche active (3) et de l'électrode de porte (5) en du matériau de couches de poly-silicium en utilisant le procédé de cristallisation latérale induite par du métal comprend :
de déposer du Ni métallique dans les ouvertures pour le dépôt de Ni et sur l'électrode de porte (5) et d'implanter des ions de source/de drain dans les ouvertures pour le dépôt de Ni de manière à former les régions de source/de drain, puis d'effectuer un recuit à haute température.
